# EUROPÄISCHE PATENTANMELDUNG

(11) **EP 2 908 146 A1**
(43) Veröffentlichungstag der Anmeldung: **19.08.2015**
(21) Anmeldenummer: 14184968.7
(22) Anmeldetag: 16.09.2014
(51) Int. Cl.: G01R 31/02, H02H 3/08, H02H 3/10, H02H 3/16, G01R 31/327

(54) **Testgerät und Testverfahren für einen Brandschutzschalter**

(30) Priorität: 12.02.2014 DE 102014202533
(71) Anmelder: Siemens Aktiengesellschaft, 80333 München (DE)
(72) Erfinder: Fehlner, Tobias, 93138 Lappersdorf (DE); Meier, Stefan, 93128 Regenstauf (DE); Spangler, Rudolf, 93152 Nittendorf (DE)

(57) **Zusammenfassung**

Das erfindungsgemäße Testgerät (10) für einen Brandschutzschalter (1) weist einen elektrischen ersten Eingang (11), welcher mit einem ersten Ausgang (4) des Brandschutzschalters (1) elektrisch koppelbar ist, sowie einen elektrischen zweiten Eingang (12), welcher mit einem zweiten Ausgang (5) des Brandschutzschalters (1) elektrisch koppelbar ist, auf. Der erste Eingang (11) und der zweite Eingang (12) sind dabei über eine Serienschaltung, bestehend aus einer elektrischen Last (14) und einem Gasableiter (15), elektrisch miteinander verbunden. Mit Hilfe des erfindungsgemäßen Testgerätes (10) wird zwischen dem ersten Eingang (11) und dem zweiten Eingang (12) des Brandschutzschalters (1), sofern zwischen diesen eine elektrische Spannung anliegt, zu Testzwecken ein realer Lichtbogen erzeugt, dessen charakteristisches elektrisches Signal anschließend von dem Brandschutzschalter (1) erfasst wird. Auf diese Weise kann auf eine aufwändige Signalerzeugung zur Simulation des charakteristischen Stromverlaufs eines Störlichtbogens verzichtet werden. Das erfindungsgemäße Testgerät (10) stellt somit eine einfache und kostengünstige Alternative zur Überprüfung der Funktionsfähigkeit eines Brandschutzschalters (1) dar. Ferner kann das Testgerät (10) aufgrund seines einfachen Aufbaus äußerst kompakt gestaltet werden, was insbesondere für eine mobile Verwendung, beispielsweise bei der Nachrüstung eines Elektroinstallationsverteilers mit Brandschutzschaltern, von großem Vorteil ist.

## Beschreibung

Die Erfindung betrifft ein Testgerät für einen Brandschutzschalter, um die Funktionsfähigkeit des Brandschutzschalters zu überprüfen. Weiterhin betrifft die Erfindung ein Testverfahren zur Überprüfung der Funktionsfähigkeit eines Brandschutzschalters.

In der Elektroinstallationstechnik wird unter dem Begriff "Brandschutzschalter" eine Schutzeinrichtung zum Schutz vor Fehler- bzw. Störlichtbögen verstanden. Derartige Fehlerlichtbogen-Schutzeinrichtungen, in der Fachsprache und im Englischen als Arc Fault Detection Device (abgekürzt AFDD) und im nordamerikanischen Raum als Arc Fault Circuit Interrupter (abgekürzt AFCI) bezeichnet, werden in Niederspannungsnetzen eingesetzt, um die elektrische Installationstechnik vor Beschädigung durch Fehlerlichtbogen sowie deren thermischen Folgen, beispielsweise Kabelbränden, zu schützen.

Ein Störlichtbogen kann beispielsweise an einer defekten Stelle einer elektrischen Leitung, beispielsweise eine lockere Kabelklemme, oder aufgrund eines Kabelbruchs auftreten. Tritt der Störlichtbogen elektrisch in Reihe zu einem elektrischen Verbraucher auf, so wird der normale Betriebsstrom im Regelfall nicht überschritten, da er durch den Verbraucher begrenzt wird. Aus diesem Grund wird der Störlichtbogen von einer herkömmlichen Überstromschutzeinrichtung, beispielsweise einer Schmelzsicherung oder eines Leitungsschutzschalters, nicht erfasst. Dies ist insbesondere bei hohen Betriebsströmen sowie bei über längere Zeit bestehenden Lichtbögen problematisch, da in diesen Fällen aufgrund der hohen Temperaturen die Gefahr eines Brandes besteht.

Zur Ermittlung, ob ein Störlichtbogen vorliegt, werden durch den Brandschutzschalter sowohl der Spannungsverlauf als auch der Stromverlauf über die Zeit gemessen und mittels digitaler Signalverarbeitung bewertet. Insbesondere der Stromverlauf weist bei Störlichtbögen charakteristische, hochfrequente Komponenten auf. Bei der Auswertung ist jedoch zu beachten, dass reguläre Schwankungen im Stromverlauf sowie im normalen Betrieb auftretende Oberschwingungen oder transiente Stromverläufe beim Einschaltvorgang von Verbrauchern nicht zu einer fehlerhaften Auslösung des Brandschutzschalters führen dürfen.

Um die Funktionsfähigkeit des Brandschutzschalters nach erfolgter Elektroinstallation überprüfen zu können, wird ein geeignetes Testgerät benötigt. Derartige Testgeräte zur Überprüfung einer korrekten Installation durch Servicepersonen oder Elektroinstallateure existieren beispielsweise bereits für sogenannte Fehlerstromschutzschalter (kurz: FI-Schalter). Diese können bzw. müssen unmittelbar nach der Installation direkt im Elektroverteiler getestet und abgenommen werden. Hierzu erzeugt das Testgerät einen Fehlerstrom, welchen der FI-Schalter erkennen und abschalten muss.

Für Brandschutzschalter werden zur Funktionsprüfung nach der Montage im Werk sogenannte Rauschgeneratoren eingesetzt, die ein lichtbogenähnliches Signal in Nieder- und Hochfrequenzbereichen erzeugen. Dieses Verfahren hat jedoch den Nachteil, dass das in dem so erzeugte Signal nicht alle elektrischen Charakteristika eines Lichtbogens hundertprozentig nachgebildet werden können, so dass der Brandschutzschalter im Test mit derartigen Signalen möglicherweise nicht auslöst. Damit ist dieses Vorgehen als universelle Testmethode zur Überprüfung der ordnungsgemäßen Installation sowie der Funktionsfähigkeit des Brandschutzschalters nur bedingt geeignet. Lösungen zur Erzeugung eines Lichtbogens durch eine Lichtbogenstrecke mit gesteuerten Elektroden oder karbonisiertes Kabel sind sehr aufwändig zu realisieren und daher zur Überprüfung direkt am Ort Elektroinstallation kaum geeignet.

Es ist deshalb die Aufgabe der vorliegenden Erfindung, ein Testgerät sowie ein Testverfahren bereitzustellen, welche eine einfache und zuverlässige Überprüfung der Funktionsfähigkeit eines Brandschutzschalters ermöglichen.

Diese Aufgabe wird durch das Testgerät sowie das Testverfahren für einen Brandschutzschalter gemäß den unabhängigen Ansprüchen gelöst. Vorteilhafte Ausgestaltungen sind Gegenstand der abhängigen Ansprüche.

Das erfindungsgemäße Testgerät für einen Brandschutzschalter weist einen elektrischen ersten Eingang, welcher mit einem ersten Ausgang des Brandschutzschalters elektrisch koppelbar ist, sowie einen elektrischen zweiten Eingang, welcher mit einem zweiten Ausgang des Brandschutzschalters elektrisch koppelbar ist, auf. Der erste Eingang und der zweite Eingang sind dabei über eine Serienschaltung, bestehend aus einer elektrischen Last und einem Gasableiter, elektrisch miteinander verbunden.

Mit Hilfe des erfindungsgemäßen Testgerätes wird zwischen dem ersten und dem zweiten Eingang des Brandschutzschalters, sofern zwischen diesen beiden Eingängen eine elektrische Spannung anliegt, zu Testzwecken ein realer Lichtbogen erzeugt, dessen charakteristisches elektrisches Signal anschließend von dem Brandschutzschalter erfasst wird. Auf diese Weise kann auf eine aufwändige Signalerzeugung zur Simulation des charakteristischen Stromverlaufs eines Störlichtbogens verzichtet werden. Das erfindungsgemäße Testgerät stellt somit eine einfache und kostengünstige Alternative zur Überprüfung der Funktionsfähigkeit eines Brandschutzschalters dar. Ferner kann das Testgerät aufgrund seines einfachen Aufbaus äußerst kompakt gestaltet werden, was insbesondere für eine mobile Verwendung, beispielsweise bei der Nachrüstung eines Elektroinstallationsverteilers mit Brandschutzschaltern, von großem Vorteil ist.

Unter dem Begriff Gasableiter wird hierbei eine Gasentladungsröhre verstanden, welche in der Regel als Überspannungsableiter zum Schutz vor Überspannungsimpulsen, beispielsweise aufgrund eines Blitzschlages, eingesetzt wird. Im englischsprachigen Raum werden derartige Gasentladungsröhren auch aus "gas discharge tubes", oder abgekürzt als GDT, bezeichnet. Bei Überschreiten einer sogenannten Zündspannung wird die Überspannung durch das selbsttätige Zünden einer Gasentladung abgebaut. Unterhalb dieser Zündspannung verhält sich das elektrisch parallel zu der zu schützenden Leitung angeschlossene Bauteil hingegen wie ein Isolator.

In einer vorteilhaften Weiterbildung weist das Testgerät ein Isolierstoffgehäuse auf, in dem der Gasableiter aufgenommen und gehaltert ist. Auf diese Weise wird die Sicherheit bei der Handhabung des Testgerätes deutlich erhöht. Dies gilt insbesondere für ein manuell bedienbares, mobiles Testgerät.

In einer weiteren vorteilhaften Weiterbildung des Testgerätes ist auch die elektrische Last in dem Isolierstoffgehäuse angeordnet. Die elektrische Last wirkt für den Gasableiter als Strombegrenzer und kann beispielsweise als normaler elektrischer Verbraucher über zwei Ausgänge an das Testgerät angeschlossen werden. Alternativ dazu kann die elektrische Last als eigenes Bauelement bereits in das Isolierstoffgehäuse integriert sein. Der Anschluss einer externen elektrischen Last ist damit nicht mehr erforderlich, wodurch sich die Handhabung des Testgerätes weiter verbessert.

In einer weiteren vorteilhaften Weiterbildung des Testgerätes weist das Isolierstoffgehäuse im Bereich des Gasableiters (15) ein Sichtfenster auf. Auf diese Weise kann der beim Test im Gasableiter erzeugte Lichtbogen einfach und komfortabel beobachtet werden.

In einer weiteren vorteilhaften Weiterbildung weist das Testgerät einen Schalter auf, welcher mit der elektrischen Last und dem Gasableiter elektrisch in Reihe geschaltet ist. Mit Hilfe des Schalters kann der Zeitpunkt des Tests unabhängig von dem elektrischen Anschluss des Testgerätes an den Brandschutzschalter bestimmt werden. Damit ist gewährleistet, dass der Lichtbogen nicht bereits beim Verbinden des ersten und zweiten Eingangs des Testgerätes mit dem ersten und zweiten Ausgang des Brandschutzschalters, sondern erst beim Schließen des Schalters erzeugt wird. Die Handhabung des Testgerätes weiter hierdurch weiter verbessert.

In einer weiteren vorteilhaften Weiterbildung des Testgerätes ist der Schalter durch ein an einem Gehäuse angeordnetes Betätigungsmittel betätigbar. Auf diese Weise kann Zeitpunkt des Tests durch den Bediener manuell durch Betätigen des Betätigungsmittels bestimmt werden. Die Handhabung des Testgerätes, insbesondere bei einer mobilen Verwendung, weiter hierdurch weiter verbessert.

In einer weiteren vorteilhaften Weiterbildung weist das Testgerät ein Verbindungskabel auf, welches seinerseits zwei elektrische Leitungen aufweist, deren erste Enden an den ersten Eingang und den zweiten Eingang des Testgerätes angeschlossen sind, und deren zweite Enden jeweils ein Kontaktelement aufweisen, welche zur Kontaktierung mit dem ersten Ausgang und dem zweiten Ausgang des Brandschutzschalters ausgebildet sind. Auf diese Weise ist kein separates Verbindungskabel zur elektrischen Verbindung des Testgerätes mit dem Brandschutzschalter erforderlich. Indem die Kontaktelemente derart gestaltet sind, dass sie auf einfache Art und Weise mit den Ausgängen des Brandschutzschalters verbindbar sind, wird die Handhabung des Testgerätes weiter verbessert.

In einer weiteren vorteilhaften Weiterbildung des Testgerätes sind die beiden Kontaktelemente zu einem gemeinsamen Stecker, welcher derart ausgebildet ist, dass er in eine Hausanschlusssteckdose einsteckbar ist, zusammengefasst.

Wird ein Brandschutzschalter beispielsweise zum Schutz einer elektrischen Hausanschlussleitung, beispielsweise der in Deutschland üblichen 230V-Leitung, verwendet, so werden der Phasenleiter und der Neutralleiter mit den beiden Ausgängen des Brandschutzschalters elektrisch leitend verbunden. In diesem Fall kann auf einfache Art und Weise eine elektrische Verbindung des Testgerätes mit dem Brandschutzschalter dadurch erfolgen, dass die beiden Kontaktelemente als Kontaktstifte eines Standardsteckers, d.h. in Deutschland beispielsweise als sog. Schuko-Stecker ausgebildet sind. Auf diese Weise kann das Testgerät durch einfaches Einstecken des Standardsteckers in eine Hausanschlusssteckdose, welche mit dem zu überprüfenden Brandschutzschalter in vorstehend bezeichneter Art elektrisch leitend verbunden ist, mit dem Brandschutzschalter elektrisch verbunden werden. Durch die mechanische Kopplung der beiden Kontaktelemente zu einem gemeinsamen Stecker wird weiterhin die Handhabung des Testgerätes weiter verbessert, da im Vergleich zu zwei einzelnen Kontakten nur noch eine Bewegung zur Kontaktierung erforderlich ist.

Die Verwendung des in Deutschland gebräuchlichen Schuko-Steckers stellt dabei nur eine von vielen, länderspezifisch unterschiedlichen Möglichkeiten dar. Je nach vorherrschender Elektroinstallation kann ein für die Elektroinstallation entsprechend geeigneter Standardstecker verwendet werden.

Das erfindungsgemäße Testverfahren zur Überprüfung der Funktionsfähigkeit eines Brandschutzschalters mittels eines mobilen Testgerätes weist die Schritte
a) Verbinden eines ersten Eingangs des Testgerätes mit einem ersten Ausgang des Brandschutzschalters,
b) Verbinden eines zweiten Eingangs des Testgerätes mit einem zweiten Ausgang des Brandschutzschalters,
c) Beaufschlagen des Testgerätes mit einer zwischen dem ersten Eingangs und dem zweiten Eingang anliegenden Nennspannung,
d) Erzeugen eines Lichtbogens mit Hilfe des Testgerätes, und
e) Erfassen des Lichtbogens durch den Brandschutzschalter,
auf. Mit Hilfe dieses Testverfahrens lässt sich auf einfache Art und Weise die Funktionsfähigkeit eines Brandschutzschalters zuverlässig überprüfen. Hierzu wird mittels des mobilen Testgerätes ein realer Lichtbogen erzeugt, welcher von dem Brandschutzschalter registriert werden soll. Damit können Fehlauslösungen, wie sie bei einer Simulation des Lichtbogensignals auftreten können, vermieden werden.

In einer vorteilhaften Weiterbildung des Testverfahrens wird der Lichtbogen durch eine elektrische Serienschaltung aus einer elektrischen Last und einem Gasableiter erzeugt. Die Verwendung eines Gasableiters stellt eine einfache Möglichkeit zur Erzeugung eines Lichtbogens zu Testzwecken dar. Dies ist insbesondere für mobile Anwendungen, beispielsweise bei der Nachrüstung eines Elektroinstallationsverteilers mit Brandschutzschaltern, von großem Vorteil.

In einer weiteren vorteilhaften Weiterbildung des Testverfahrens sind der erste Eingang mit einem ersten Kontaktstift und der zweite Eingang mit einem zweiten Kontaktstift elektrisch leitend verbunden. Dabei erfolgt das Verbinden mit dem ersten und zweiten Ausgang des Brandschutzschalters durch Einstecken des ersten und zweiten Kontaktstiftes in eine Hausanschlusssteckdose, deren Kontakte mit dem ersten und zweiten Ausgang des zu überprüfenden Brandschutzschalters elektrisch leitend verbunden sind. Das Einstecken der Kontaktstifte in eine mit dem Brandschutzschalter elektrisch verbundene Hausanschlusssteckdose stellt eine einfache und kostengünstige Möglichkeit dar, um eine elektrische Verbindung des Testgerätes mit dem Brandschutzschalter herzustellen. Die Ausführung des Testverfahrens wird hierdurch deutlich vereinfacht.

In einer weiteren vorteilhaften Weiterbildung des Testverfahrens erfolgen die Schritte a) und b) gleichzeitig. Durch Verwendung eines geeigneten Steckverbinders, in dem die beiden Kontaktstifte aufgenommen und gehaltert sind, können die beiden Kontaktstifte gleichzeitig mit dem ersten Ausgang und dem zweiten Ausgang des Brandschutzschalters elektrisch leitend verbunden werden. Erfolgt die Verbindung über eine Hausanschlusssteckdose, so kann als Steckverbinder ein zur Steckdose kompatibel gestalteter Standardstecker verwendet werden. In Deutschland käme hierfür beispielsweise ein sogenannter Schuko-Stecker in Betracht. Durch die Verwendung eines geeigneten Steckverbinders wird die Handhabung - und damit die Ausführung des Testverfahrens - deutlich vereinfacht. Weiterhin wird hierdurch die Sicherheit weiter verbessert.

In einer weiteren vorteilhaften Weiterbildung des Testverfahrens erfolgt auch Schritt c) gleichzeitig mit den Schritten a) und b). Auf diese Weise wird die Durchführung des Testverfahrens beschleunigt und somit weiter vereinfacht.

Im Folgenden werden mögliche Ausführungsbeispiele des Testgerätes unter Bezug auf die beigefügten Figuren näher erläutert. In den Figuren sind:
- Figuren 1A bis 1C: schematische Darstellungen verschiedener Ausführungsformen des erfindungsgemäßen Testgerätes;
- Figur 2: eine schematische Darstellung einer alternativen Anschlussmöglichkeit des erfindungsgemäßen Testgerätes an einen Brandschutzschalter.

In den verschiedenen Figuren der Zeichnung sind gleiche Teile stets mit dem gleichen Bezugszeichen versehen. Die Beschreibung gilt für alle Zeichnungsfiguren, in denen das entsprechende Teil ebenfalls zu erkennen ist.

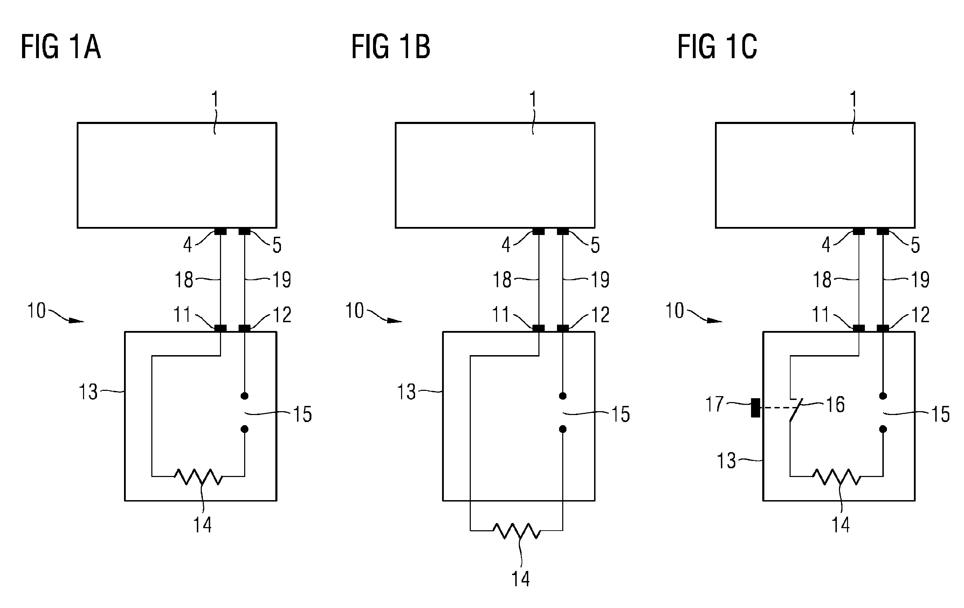

In den Figuren 1A bis 1C sind unterschiedliche Ausführungsformen des erfindungsgemäßen Testgerätes 10 zum Testen der Funktionsfähigkeit eines Brandschutzschalters 1 schematisch dargestellt. Figur 1 zeigt dabei ein Testgerät 1, dessen erster Eingang 11 über eine erste elektrische Leitung 18 mit einem ersten Ausgang 4 des Brandschutzschalters 1, und dessen zweiter Eingang 12 über eine zweite elektrische Leitung 19 mit einem zweiten Ausgang 5 des Brandschutzschalters 1 elektrisch leitend verbunden sind. Im Inneren eines Gehäuses 13 weist das Testgerät eine elektrische Last 14 sowie einen Gasableiter 15 auf, welche zu dem ersten Eingang 11 und dem zweiten Eingang 12 elektrisch in Reihe geschaltet sind. Liegt zwischen dem ersten Ausgang 4 und dem zweiten Ausgang 5 des Brandschutzschalters 1 eine elektrische Spannung an, welche größer als eine zum Zünden des Gasableiters erforderliche Zündspannung ist, so entsteht mit der Kontaktierung des Testgerätes 10 mit dem Brandschutzschalter 1 ein Lichtbogen zwischen den beiden Kontakten des Gasableiters 15. Der Lichtbogenstrom wird dabei von der elektrischen Last 14 begrenzt und fließt solange, bis der Brandschutzschalter 1 auslöst und den Stromfluss unterbricht.

Figur 1B zeigt eine alternative Ausführungsform des Testgerätes 10. Dabei ist die elektrische Last 14 nicht innerhalb, sondern außerhalb des Gehäuses 13 angeordnet. Dabei kann ein bereits vorhandener elektrischer Verbraucher als elektrische Last 14 verwendet werden.

In Figur 1C ist eine weitere alternative Ausführungsform des Testgerätes 10 schematisch dargestellt. Das Testgerät 10 weist einen Schalter 16 auf, welche mit der elektrischen Last 14 und dem Gasableiter 15 elektrisch in Reihe geschaltet ist. Der Schalter 16 ist dabei als mechanischer Schalter ausgebildet, welcher mit Hilfe eines Betätigungsmittels 17 manuell betätigbar ist. Auf diese Weise kann das Testgerät 10 zunächst mit dem Brandschutzschalter 1 elektrisch leitend verbunden werden, ohne dass damit bereits unmittelbar ein Lichtbogen entsteht. Dies ist erst der Fall, wenn der Schalter 16 durch Betätigen des Betätigungsmittels 17 geschlossen wird.

Die in den Figuren 1A bis 1C dargestellten Ausführungsformen des Testgerätes 10 stellen nur beispielhafte Ausführungsformen dar, welche beliebig miteinander kombinierbar sind. Beispielsweise kann bei einem Testgerät 10 gemäß der Darstellung in Figur 1C die elektrische Last 14 auch außerhalb des Gehäuses 13 angeordnet sein.

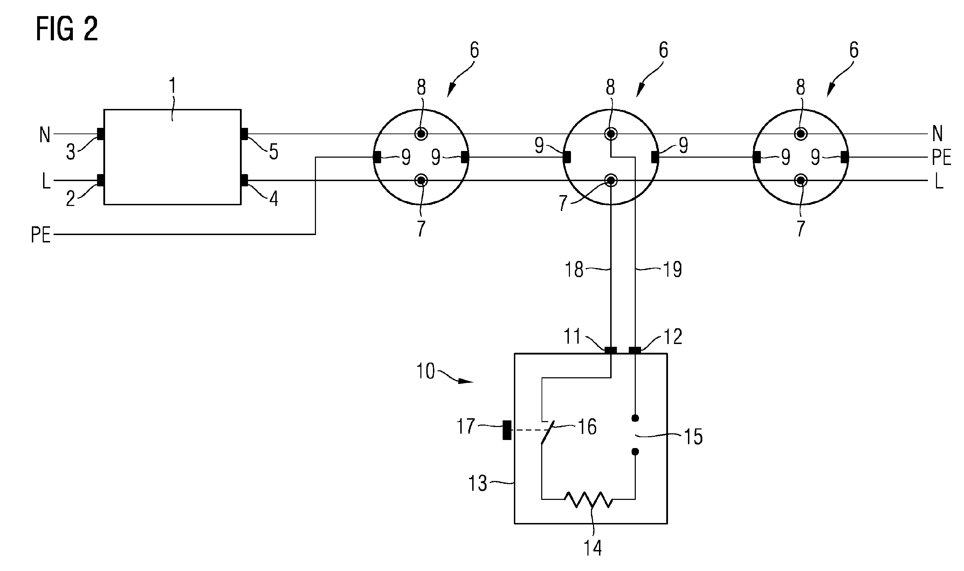

In Figur 2 ist eine alternative Anschlussmöglichkeit des erfindungsgemäßen Testgerätes 10 an den Brandschutzschalter 1 schematisch dargestellt. Der Brandschutzschalter 1 dient dabei beispielhaft der Absicherung eines Stromzweiges eines 230V-Einphasen-Wechselstromnetzes. Er ist hierzu über einen ersten Eingang 2 an einen Phasenleiter L des Wechselstromnetzes und über einen zweiten Eingang 3 an einen Neutralleiter N des Wechselstromnetzes angeschlossen. Ein zu dem Wechselstromnetz gehöriger Schutzleiter PE ist an dem Brandschutzschalter 1 vorbeigeführt.

Über den ersten Ausgang 4 und den zweiten Ausgang 5 des Brandschutzschalters 1 sind mehrere Hausanschlusssteckdosen 6 mit dem Brandschutzschalter 1 in einer Reihenschaltung elektrisch leitend verbunden. Die Hausanschlusssteckdosen 6 weisen jeweils eine erste Kontaktbuchse 7 zum Anschluss des Phasenleiters L sowie eine zweite Kontaktbuchse 8 zum Anschluss des Neutralleiters N auf. Die Kontaktbuchsen dienen der Aufnahme und elektrischen Kontaktierung von Steckkontakten, wie sie beispielsweise in der Ausführung eines sogenannten Schuko-Steckers (nicht dargestellt) paarweise zusammengefasst sind. Weiterhin weisen die Hausanschlusssteckdosen 6 je zwei Federkontakte 9 auf, welche mit dem Schutzleiter PE elektrisch leitend verbunden sind.

Im Unterschied zu den Darstellungen der Figuren 1A bis 1C ist das in Figur 2 dargestellte Testgerät 10 über eine der Hausanschlusssteckdosen 6 mit dem Brandschutzschalter 1 elektrisch leitend verbunden. Hierzu ist das Testgerät 10 über die an den ersten Eingang 11 angeschlossene elektrische erste Leitung 18 mit der ersten Kontaktbuchse 7 der Hausanschlusssteckdose 6 elektrisch leitend verbunden. Der zweite Eingang 12 des Testgerätes 10 ist über die elektrische zweite Leitung 19 mit der zweiten Kontaktbuchse 8 der Hausanschlusssteckdose 6 elektrisch leitend verbunden. Der weitere elektrische Aufbau des in Figur 2 dargestellten Testgerätes 10 entspricht dabei dem in den Figur 1C dargestellten Ausführungsbeispiel. Es ist jedoch ebenso möglich, eines der in den Figuren 1A oder 1B dargestellten und vorstehend beschriebenen Ausführungsbeispiele des Testgerätes 10 in der in Figur 2 gezeigten Art und Weise über eine herkömmliche Hausanschlusssteckdose 6 mit dem Brandschutzschalter 1 elektrisch leitend zu verbinden.

Die elektrisch leitende Verbindung des Testgerätes 10 mit der Hausanschlusssteckdose 6 kann dabei mit Hilfe eines gemeinsamen Kabels, in dem die elektrische erste Leitung 18 und die elektrische zweite Leitung 19 aufgenommen sind, erfolgen. Dieses Kabel kann dabei lösbar mit dem ersten Eingang 11 und dem zweiten Eingang 12 verbunden sein. Es ist jedoch ebenso möglich, dass das Kabel fest mit dem Testgerät 10 verbunden und aus dem Isolierstoffgehäuse 13 herausgeführt ist. Weiterhin ist die Kontaktierung des Kabels mit der Hausanschlusssteckdose 6 über einen Schuko-Stecker realisierbar. Dies ist jedoch nicht zwingend erforderlich. Es ist ebenso möglich, eine andere Steckerbauform zu verwenden, sofern diese mit der jeweiligen Bauform der Hausanschlussteckdose kompatibel ist. Ferner ist sowohl die Anwendung des Testgerätes 10 als auch dessen leitende Verbindung mit dem Brandschutzschalter nicht auf das in Figur 2 dargestellte 230V-Einphasen-Wechselstromnetz beschränkt.

Mit Hilfe des erfindungsgemäßen Testgerätes 10 kann die Funktionsfähigkeit eines Brandschutzschalters 1 mit Hilfe eines realen Lichtbogens getestet werden. Dieser wird in dem Gasableiter 15 erzeugt und dem Brandschutzschalter 1 als Signal in vorstehend beschriebener Art und Weise zugeführt. Damit steht ein universell einsetzbares Testgerät zur Verfügung, mit dessen Hilfe jeder Brandschutzschalter - unabhängig vom jeweiligen Hersteller - auf seine Funktionsfähigkeit, d.h. auf seine ordnungsgemäße Auslösung hin, überprüft werden kann. Dabei brennt der Lichtbogen kontrolliert und räumlich begrenzt in einem einzigen Bauteil - dem Gasableiter 15. Die elektrische Schaltung des Testgerätes 10 ist dabei extrem einfach, robust und kostengünstig. Eine Beobachtung der Lichtbogens ist durch Einbringung eines Sichtfensters in das Isolierstoffgehäuse 13 des Testgerätes 10 - bei Verwendung eines Gasableiters mit durchsichtigem Gehäuse - realisierbar.

Um die Belastungsdauer des Gasableiters 15 zu begrenzen, kann der Schalter 16 mit einem Zeitzähler versehen werden, dessen Zeitgrenze beispielsweise von der Stromlast abhängig ist. Auf diese Weise ist eine Funktionsüberprüfung des Brandschutzschalters 1 nach IEC-Auslösekennlinie möglich.

Weiterhin kann der Gasableiter 15 fest aber lösbar in dem Isolierstoffgehäuse 13 aufgenommen und gehaltert sein. Auf diese Weise ist ein Wechsel des Gasableiters für den Anwender einfach, schnell und sicher durchzuführen.

Ferner kann die elektrische Last 14 auch umschaltbar oder veränderbar ausgebildet sein, beispielsweise um unterschiedliche Testverfahren bei verschiedenen elektrischen Lastzuständen durchführen zu können.

Schließlich ist es möglich, das Vorhandensein einer Netzspannung an zwischen dem ersten Eingang 11 und dem zweiten Eingang 12 des Testgerätes 10 mittels eines geeigneten Anzeigeelements, beispielsweise eines Signallämpchens, anzuzeigen.

### Bezugszeichenliste

- 1: Brandschutzschalter
- 2: erster Eingang
- 3: zweiter Eingang
- 4: erster Ausgang
- 5: zweiter Ausgang
- 6: Hausanschlusssteckdosen
- 7: erste Kontaktbuchse
- 8: zweite Kontaktbuchse
- 9: Federkontakt
- 10: Testgerät
- 11: erster Eingang
- 12: zweiter Eingang
- 13: Isolierstoffgehäuse
- 14: elektrischen Last
- 15: Gasableiter
- 16: Schalter
- 17: Betätigungsmittel
- 18: erste Leitung
- 19: zweite Leitung

- PE: Phasenleiter
- N: Neutralleiter
- PE: Schutzleiter

## Patentansprüche

1. Testgerät (10) für einen Brandschutzschalter (1), mit
- einem elektrischen ersten Eingang (11), welcher mit einem ersten Ausgang (4) des Brandschutzschalters (1) elektrisch koppelbar ist,
- einem elektrischen zweiten Eingang (12), welcher mit einem zweiten Ausgang (5) des Brandschutzschalters (1) elektrisch koppelbar ist,
wobei der erste Eingang (12) und der zweite Eingang (13) über eine elektrische Serienschaltung aus einer elektrischen Last (14) und einem Gasableiter (15) elektrisch miteinander verbunden sind.

2. Testgerät (10) nach Anspruch 1, welches ein Isolierstoffgehäuse (13) aufweist, in dem der Gasableiter (15) aufgenommen und gehaltert ist.

3. Testgerät (10) nach Anspruch 2, wobei auch die elektrische Last (14) in dem Isolierstoffgehäuse (13) angeordnet ist.

4. Testgerät (10) nach einem der Ansprüche 2 oder 3, wobei das Isolierstoffgehäuse (13) im Bereich des Gasableiters (15) ein Sichtfenster aufweist.

5. Testgerät (10) nach einem der vorherigen Ansprüche, welches einen Schalter (16) aufweist, welcher mit der elektrischen Last (14) und dem Gasableiter (15) elektrisch in Reihe geschaltet ist.

6. Testgerät nach Anspruch 5, wobei der Schalter (16) durch ein an einem Gehäuse (13) angeordnetes Betätigungsmittel (17) betätigbar ist.

7. Testgerät nach Anspruch 1, mit einem Verbindungskabel (18), welches zwei elektrische Leitungen aufweist, deren erste Enden an den ersten Eingang (11) und den zweiten Eingang (12) angeschlossen sind, und deren zweite Enden jeweils ein Kontaktelement zur Kontaktierung mit dem ersten Ausgang (4) und dem zweiten Ausgang (5) des Brandschutzschalters (1) aufweisen.

8. Testgerät nach Anspruch 7, wobei die beiden Kontaktelemente zu einem gemeinsamen Stecker zusammengefasst sind, welcher derart ausgebildet ist, dass er in eine Hausanschlusssteckdose einsteckbar ist.

9. Testverfahren zur Überprüfung der Funktionsfähigkeit eines Brandschutzschalters (1) mittels eines mobilen Testgerätes (10), mit den Schritten:
a) Verbinden eines ersten Eingangs (11) des Testgerätes (10) mit einem ersten Ausgang (4) des Brandschutzschalters (1),
b) Verbinden eines zweiten Eingangs (12) des Testgerätes (10) mit einem zweiten Ausgang (5) des Brandschutzschalters (1),
c) Beaufschlagen des Testgerätes (10) mit einer zwischen dem ersten Eingang (11) und dem zweiten Eingang (12) anliegenden Nennspannung,
d) Erzeugen eines Lichtbogens mit Hilfe des Testgerätes (10),
e) Erfassen des Lichtbogens durch den Brandschutzschalter (1).

10. Testverfahren nach Anspruch 9, wobei der Lichtbogen durch eine elektrische Serienschaltung aus einer elektrischen Last (14) und einem Gasableiter (15) erzeugt wird.

11. Testverfahren nach einem der Ansprüche 9 oder 10, wobei der erste Eingang (11) mit einem ersten Kontaktstift und der zweite Eingang (12) mit einem zweiten Kontaktstift elektrisch leitend verbunden sind und das Verbinden mit dem ersten und zweiten Ausgang (4, 5) des Brandschutzschalters (1) durch Einstecken des ersten und zweiten Kontaktstiftes in eine Hausanschlusssteckdose erfolgt, deren Kontakte mit dem ersten und zweiten Ausgang (4, 5) des zu überprüfenden Brandschutzschalters (1) elektrisch leitend verbunden sind.

12. Testverfahren nach einem der Ansprüche 8 bis 11, wobei die Schritte a) und b) gleichzeitig erfolgen.

13. Testverfahren nach Anspruch 12, wobei auch Schritt c) gleichzeitig mit den Schritten a) und b) erfolgt.
